# EUROPEAN PATENT APPLICATION

(11) **EP 4 212 960 A1**
(43) Date of publication of application: **19.07.2023**
(21) Application number: 22151287.4
(22) Date of filing: 13.01.2022
(51) Int. Cl.: G03F 7/20

(54) **A SYSTEM FOR USE IN A LITHOGRAPHIC APPARATUS**

(71) Applicant: ASML Netherlands B.V., 5500 AH Veldhoven (NL)
(72) Inventor: LABETSKI, Dzmitry, 5500 AH Veldhoven (NL); DE HOOGH, Joost, 5500 AH Veldhoven (NL)
(74) Representative: ASML Netherlands B.V.

(57) **Abstract**

A system for use in a lithographic apparatus comprises: a substrate table; another device; and at least one deformable partition. The substrate table (for example a wafer stage) is arranged to support a substrate. The system is configurable in a first configuration such that a surface of the device faces and is adjacent to the substrate and the substrate table. The at least one deformable partition either: (a) extends partially from the substrate table towards the surface of the device when the system is in the first configuration; or (b) extends partially from the surface of the device that faces and is adjacent to the substrate and the substrate table when the system is in the first configuration towards the substrate table.

## Description

### FIELD

The present invention relates to a system for use in a lithographic apparatus. In general, the system may comprise a substrate table (for example a wafer stage) for use in a lithographic apparatus. The lithographic apparatus may be an extreme ultraviolet (EUV) lithographic apparatus. The system may further comprise another device that, in use, is positioned adjacent to, and facing, the substrate table.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

It may be desirable to at least partially address one or more problems associated with known lithographic apparatus, whether identified herein or otherwise.

### SUMMARY

According to a first aspect of the present disclosure there is provided a system comprising: a substrate table arranged to support a substrate; a device, wherein the system is configurable in a first configuration such that a surface of the device faces and is adjacent to the substrate and the substrate table; and at least one deformable partition either: (a) extending partially from the substrate table towards the surface of the device when the system is in the first configuration; or (b) extending partially from the surface of the device that faces and is adjacent to the substrate and the substrate table when the system is in the first configuration towards the substrate table.

The system according to the first aspect may form part of a lithographic apparatus.

The device may comprise a projection system configured to project a patterned radiation beam onto a substrate supported by the substrate table. The device may further comprise a heat shield. Such projection system and heat shield may define a surface that faces the substrate table while the projection system is projecting the patterned radiation beam onto a substrate supported by the substrate table.

Alternatively, the device may comprise parts of a lithographic apparatus that are used to perform measurements of a substrate (for example a resist coated silicon wafer) supported by the substrate table (for example a wafer stage) before exposure of the substrate to patterned radiation.

The system is configurable in a first configuration such that a surface of the device faces and is adjacent to the substrate and the substrate table. A configuration of the system may be changed by moving the substrate table relative to the device. In some embodiments the system may form part of a lithographic apparatus wherein the substrate table is positionable within the lithographic apparatus at least in: (a) an exposure location (for example proximate a projection system); and (b) a measurement location (for example proximate one or more measurement systems). Within such a lithographic apparatus, the system may be considered to be in a first configuration when the substrate table is in the exposure location and a second configuration when the substrate table is in the measurement location (or vice versa).

The system according to the first aspect is advantageous, as now discussed.

In use, the substrate table (for example a wafer stage of a lithographic apparatus) may be positioned such that at least part of the substrate faces a generally parallel surface (of the device). For example, while a projection system is projecting the patterned radiation beam onto a substrate supported by the substrate table, the substrate table is positioned such that part of the substrate receives the patterned radiation from the projection system. The rest of the substrate faces a generally parallel surface, which may, for example, comprise a heat shield.

As discussed further below, it can be beneficial to reduce a gap between some parts of the substrate and surrounding apparatus (for example, to reduce the amount of particles and/or radiation passing to or from certain parts of the substrate). To this end, it may be beneficial to reduce the distance between the substrate table (or substrate) and a facing surface. However, there is a limit to the minimum distance that can be achieved as it is undesirable for the substrate or substrate table to contact the facing surface. Furthermore, some tolerance may be allowed to prevent such contact in the event of an earthquake or the like to prevent damage to the substrate, substrate table or the facing surface.

Advantageously, the at least one deformable partition of the system according to the first aspect further reduces a gap between some parts of the substrate and surrounding apparatus. The at least one deformable partition extends from a first member (at its proximal end) partially towards a second member (at its distal end). The first and second members are: (a) the substrate table; or (b) a surface of the device facing the substrate table. If the first and second members move towards each other (for example in the event of an earthquake) the second member may contact the distal end of the deformable partition, causing it to deform. Since the at least one partition is deformable, advantageously, such contact may not result in damage to either the substrate or the surface facing it in use (for example a heat shield). Advantageously, therefore, the system according to the first aspect allows a physical gap between the substrate table (or substrate) and an adjacent surface to be reduced whilst limiting the risk of damage.

In general, the at least one deformable partition may extend from a member on which is disposed an object that it is desired to protect. For example, for embodiments wherein the at least one deformable partition is desired to protect the substrate, the at least one deformable partition may extend from the substrate table. Similarly, for embodiments wherein the at least one deformable partition is desired to protect something disposed on the device that faces and is adjacent to the substrate and the substrate table the at least one deformable partition may extend from said device.

The device may comprise a projection system configured to project a patterned radiation beam through an opening and onto a substrate supported by the substrate table.

Such projection system may face the substrate table while the projection system is projecting the patterned radiation beam onto a substrate supported by the substrate table.

The device may further comprise one or more components extending from the opening and at least partially defining the surface of the device that faces and is adjacent to the substrate and the substrate table when the system is in the first configuration.

Said components may comprise any or all of the following: a body or housing of the projection system in which the opening is defined; a heat shield; a mirror used as part of an interferometric measuring system; and/or a spoiler configured to direct a part of a gas flow away from such a mirror.

At least one deformable partition may extend partially from the substrate table towards the surface of the device that faces and is adjacent to the substrate and the substrate table when the system is in the first configuration.

The surface facing the substrate table may comprise, or may be at least partially formed by, a heat shield.

Advantageously, a deformable partition that extends partially from the substrate table to the surface that faces the substrate table (for example during a lithographic exposure of the substrate) provides a barrier between a portion of the substrate table that supports the substrate and the surrounding portions of the substrate table and the surrounding environment. Since the deformable partition that extends from the substrate table it remains in a fixed position relative to a substrate supported by the substrate table.

In a lithographic apparatus it is desirable to reduce the number of particles incident on the substrate in order to reduce the incidence of wafer defects. A deformable partition that extends partially from the substrate table towards the surface that faces the substrate table during use (for example during a lithographic exposure of the substrate) acts to further reduce ingress of particles to a region in which the substrate is disposed from surrounding environments.

It will be appreciated that the at least one deformable partition that extends partially from the substrate table towards the surface facing the substrate table in use (for example while a projection system is projecting a patterned radiation beam onto a substrate supported by the substrate table) has at least a component of extent in a direction perpendicular to a plane of the substrate.

In principle the at least one deformable partition that extends partially from the substrate table towards the surface facing the substrate table may extend substantially entirely around a perimeter (or circumference) of a region for supporting the substrate. This would maximize the separation between the portion of the substrate table that supports the substrate and the surrounding portions of the substrate table and the surrounding environment.

The at least one deformable partition that extends partially from the substrate table towards the surface of the device that faces and is adjacent to the substrate and the substrate table when the system is in the first configuration may extend only partially around a perimeter of a region of the substrate table for supporting the substrate.

For example, in some embodiments the at least one deformable partition that extends partially from the substrate table towards the surface facing the substrate table in use extends along two opposed surfaces of a generally rectangular region of the substrate table for supporting the substrate.

Advantageously, such an arrangement may allow line of sight for a laser beam to pass from the surrounding environment to a portion of the substrate table that is adjacent to a portion of the substrate table that supports the substrate. Such a laser beam may be used, for example, as part of an interferometric measurement system for measuring the position (for example the height) of the substrate table relative to a reference frame.

The lithographic apparatus may further comprise a scanning mechanism configured to control relative positions of the substrate table and the device.

For example, the lithographic apparatus may be a lithographic scanner. The projection system may be operable to project the patterned radiation beam onto an exposure region or exposure slit. The exposure region may be an elongate (either straight or curved) region in an image plane. The scanning mechanism may be configured to position the substrate table such that a substrate supported by the substrate table lies generally in the image plane. The scanning mechanism may be further configured to move the substrate table so as to scan a target region of the substrate through the exposure region.

At least one deformable partition may extend partially towards the substrate table from a surface of the device that faces and is adjacent to the substrate and the substrate table when the system is in the first configuration.

Advantageously, a deformable partition that extends partially towards the substrate table from the surface of the device that faces the substrate table (for example during an exposure of the substrate) can provide a barrier between the exposure region (also known as a slit) and surrounding portions of the apparatus or system. Since the deformable partition extends from the surface that, in use, faces the substrate table it remains in a fixed position relative to the device (for example the projection system and any other apparatus connected thereto).

As discussed further below, it can be desirable to (a) reduce the number of particles egressing from a volume adjacent the exposure region to the surrounding environment; and/or (b) reduce the amount of radiation from a projection system that is incident on the substrate outside of the exposure region. A deformable partition that extends partially towards the substrate table from the surface of the device that faces the substrate table during use (for example during an exposure of the substrate) can achieve this.

It will be appreciated that the at least one deformable partition that extends partially towards the substrate table from the surface facing the substrate table during use (for example while the projection system is projecting the patterned radiation beam onto a substrate supported by the substrate table) has at least a component of extent in a direction perpendicular to a plane of the substrate.

The at least one deformable partition that extends partially towards the substrate table from the surface facing the substrate table may extend substantially entirely around a perimeter the exposure region. Alternatively, the at least one deformable partition that extends partially towards the substrate table from the surface facing the substrate table may extend only partially around a perimeter the exposure region.

At least one deformable partition that extends partially towards the substrate table from the surface of the device that faces and is adjacent to the substrate and the substrate table when the system is in the first configuration may comprise at least one deformable partition extending from a projection system in the vicinity of an exposure region.

The at least one deformable partition extending from the projection system in the vicinity of an exposure region may extend generally along a non-scanning direction.

At least one deformable partition that extends partially towards the substrate table from the surface of the device that faces and is adjacent to the substrate and the substrate table when the system is in the first configuration may comprise at least one deformable partition extending from a surface adjacent to a mirror used as part of an interferometric measuring system.

The at least one deformable partition extending from a surface adjacent to a mirror used as part of an interferometric measuring system may extend generally along a scanning direction.

At least one of the at least one deformable partition may be resiliently deformable.

Advantageously, such a resiliently deformable partition can deform from a nominal position if its distal end contacts another object (for example during an earthquake) and can move back to the nominal position when the object causing the deformation is removed.

Said resiliently deformable partition may have at least a component of extent in a direction parallel to a plane of the substrate.

That is, rather than extending solely perpendicular to the plane of the substrate, the resiliently deformable partition may extend at an oblique angle to the plane of the substrate. Upon exertion of a force from an object generally perpendicular to the plane of the substrate such a resiliently deformable partition may bend to the side.

Said resiliently deformable partition may be resiliently deformable in a direction generally perpendicular to the plane of the substrate.

For example, in a direction perpendicular to the plane of the substrate, the resiliently deformable partition may be generally of the form of a spring. Upon exertion of a force from an object generally perpendicular to the plane of the substrate such a resiliently deformable partition may compress in said direction.

At least one of the at least one deformable partition may comprise a frangible portion between its proximate and distal ends.

Advantageously, such a frangible portion allows the deformable partition to break if its distal end contacts another object (for example during an earthquake). Such a deformable partition may be described as permanently deformable.

According to a second aspect of the present disclosure there is provided a substrate table for use in the system of the first aspect of the present disclosure.

According to a third aspect of the present disclosure there is provided a device for use in the system the first aspect of the present disclosure.

According to a fourth aspect of the present disclosure there is provided a substrate table arranged to support a substrate, the substrate table comprising at least one deformable partition extending from the substrate table and having at least a component of extent in a direction perpendicular to a plane of a substrate when supported by the substrate table.

The substrate table according to the fourth aspect may form part of the system according to the first aspect.

In use, the substrate table may be positionable relative to another device such that a surface of the device faces and is adjacent to the substrate and the substrate table. When in such a configuration, the at least one deformable partition may extend partially from the substrate table towards a surface of the device.

Advantageously, the at least one deformable partition of the substrate table according to the fourth aspect can further reduce a gap between the substrate and surrounding apparatus. If the substrate table moves towards another device that in use is adjacent to the substrate table (for example in the event of an earthquake) the other device may contact the distal end of the deformable partition, causing it to deform. Since the at least one partition is deformable, advantageously, such contact may not result in damage to either the substrate or the surface facing it in use (for example a heat shield). Advantageously, therefore, the substrate table according to the fourth aspect allows a physical gap between the substrate table (or substrate) and an adjacent surface to be reduced whilst limiting the risk of damage.

Advantageously, the deformable partition(s) can provide a barrier between a portion of the substrate table that supports the substrate and the surrounding portions of the substrate table and the surrounding environment. Since the deformable partition extends from the substrate table it remains in a fixed position relative to a substrate supported by the substrate table.

In a lithographic apparatus it is desirable to reduce the number of particles incident on the substrate in order to reduce the incidence of wafer defects. A deformable partition that extends partially from the substrate table towards the surface that faces the substrate table during use (for example during a lithographic exposure of the substrate) acts to further reduce ingress of particles to a region in which the substrate is disposed from surrounding environments.

In principle the at least one deformable partition may extend substantially entirely around a perimeter (or circumference) of a region for supporting the substrate. This would maximize the separation between the portion of the substrate table that supports the substrate and the surrounding portions of the substrate table and the surrounding environment.

The at least one deformable partition that extends from the substrate table may extend only partially around a perimeter of a region of the substrate table for supporting the substrate.

For example, in some embodiments the at least one deformable partition that extends from the substrate table may extend along two opposed surfaces of a generally rectangular region of the substrate table for supporting the substrate.

Advantageously, such an arrangement may allow line of sight for a laser beam to pass from the surrounding environment to a portion of the substrate table that is adjacent to a portion of the substrate table that supports the substrate. Such a laser beam may be used, for example, as part of an interferometric measurement system for measuring the position (for example the height) of the substrate table relative to a reference frame.

At least one of the at least one deformable partition may be resiliently deformable.

Advantageously, such a resiliently deformable partition can deform from a nominal position if its distal end contacts another object (for example during an earthquake) and can move back to the nominal position when the object causing the deformation is removed.

Said resiliently deformable partition may have at least a component of extent in a direction parallel to a plane of the substrate when supported by the substrate table.

That is, rather than extending solely perpendicular to the plane of the substrate, the resiliently deformable partition may extend at an oblique angle to the plane of the substrate. Upon exertion of a force from an object generally perpendicular to the plane of the substrate such a resiliently deformable partition may bend to the side.

Said resiliently deformable partition may be resiliently deformable in a direction generally perpendicular to the plane of the substrate when supported by the substrate table.

For example, in a direction perpendicular to the plane of the substrate, the resiliently deformable partition may be generally of the form of a spring. Upon exertion of a force from an object generally perpendicular to the plane of the substrate such a resiliently deformable partition may compress in said direction.

At least one of the at least one deformable partition may comprise a frangible portion between its proximate and distal ends.

Advantageously, such a frangible portion allows the deformable partition to break if its distal end contacts another object (for example during an earthquake). Such a deformable partition may be described as permanently deformable.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2A schematically shows a portion of the lithographic apparatus shown in Figure 1 in the vicinity of the substrate table (and the substrate), including a part of the projection system, in cross section in a plane containing a scanning direction (the y-direction) of the lithographic apparatus;
- Figure 2B schematically shows a portion of the lithographic apparatus shown in Figure 1 in the vicinity of the substrate table (and the substrate), including a part of the projection system, in cross section in a plane containing a non-scanning direction (the x-direction) of the lithographic apparatus;
- Figure 3 shows a section of a substrate table (supporting a substrate) and a generally parallel barrier facing and adjacent to the substrate table and substrate;
- Figure 4 shows the same section of the substrate table, the substrate and the barrier as shown in Figure 3 and, in addition, shows a deformable partition extending partially from the substrate table towards a surface of the barrier;
- Figures 5A and 5B show a first example embodiment of a deformable partition of the type shown in Figure 4 that extends partially from a substrate table towards a facing surface;
- Figures 6A and 6B show a second example embodiment of a deformable partition of the type shown in Figure 4 that extends partially from a substrate table towards a facing surface;
- Figures 7A and 7B show a first example embodiment of a deformable partition of the type shown in Figure 4 that extends partially from a substrate table towards a facing surface;
- Figure 8 shows a section of a substrate table (supporting a substrate) and part of a generally parallel barrier facing and adjacent to the substrate table and substrate;
- Figure 9 shows the same section of the substrate table, the substrate and the barrier as shown in Figure 8 and, in addition, shows a deformable partition extending partially from the surface towards the substrate table;
- Figures 10A and 10B show a first example embodiment of a deformable partition of the type shown in Figure 9 that extends partially towards the substrate table from the surface, adjacent to a mirror used as part of an interferometric measuring system;
- Figures 11A and 11B show a second example embodiment of a deformable partition of the type shown in Figure 9 that extends partially towards the substrate table from the surface, adjacent to a mirror used as part of an interferometric measuring system;
- Figures 12A and 12B show a third example embodiment of a deformable partition of the type shown in Figure 9 that extends partially towards the substrate table from the surface, adjacent to a mirror used as part of an interferometric measuring system;
- Figure 13 shows a section of a substrate table (supporting a substrate) and part of a generally parallel barrier facing and adjacent to the substrate table and substrate;
- Figure 14 shows the same section of the substrate table, the substrate and the barrier as shown in Figure 8 and, in addition, shows two deformable partitions, each extending partially from a housing of the projection system towards the substrate table;
- Figures 15A and 15B show a first example embodiment of deformable partitions of the type shown in Figure 14 that extends partially towards the substrate table from the projection system in the vicinity of an exposure region;
- Figures 16A and 16B show a second example embodiment of deformable partitions of the type shown in Figure 14 that extends partially towards the substrate table from the projection system in the vicinity of an exposure region; and
- Figures 17A and 17B show a third example embodiment of deformable partitions of the type shown in Figure 14 that extends partially towards the substrate table from the projection system in the vicinity of an exposure region.

### DETAILED DESCRIPTION

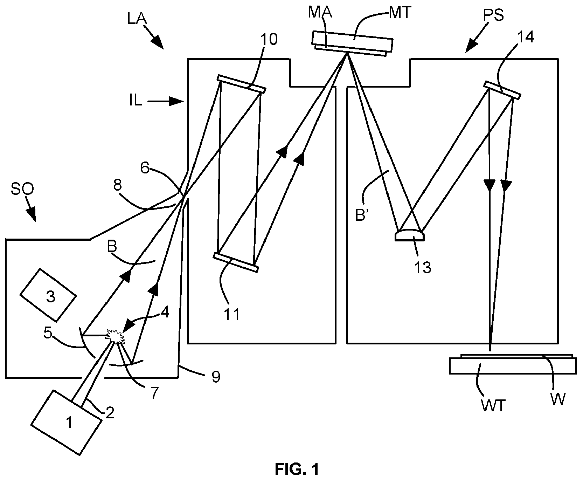

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

The projection system PS is connected to an isolated frame. For example the isolated frame (which may be referred to as a metro frame) may be supported by a base frame, which may be supported on the ground, such that it is substantially isolated from external influences (such as vibrations in the base frame). This isolation may be achieved by the use of acoustically damping mounts, which support the isolated frame on the base frame. The acoustically damping mounts may be actively controlled to isolate vibrations which are introduced by the base frame and/or by the isolated frame itself.

The support structure MT is movably mounted to the isolated frame via a first positioning device. The first positioning device may be used to move the patterning device MA, and to accurately position it, relative to the isolated frame (and the projection system PS which is connected to the frame). The substrate table WT is movably mounted to the isolated frame via a second positioning device. The second positioning device may be used to move the substrate W, and to accurately position it, relative to the isolated frame (and the projection system PS which is connected thereto).

The projection system PS has a body or housing, which defines an interior and an opening. The two mirrors 13, 14 are disposed within the interior and the projection system PS is configured and arranged to project the patterned EUV radiation beam B' through the opening onto a substrate W supported by the substrate table WT.

The projection system PS is configured to project the patterned EUV radiation beam B' onto the substrate W. In particular, the projection system PS is configured to project the patterned EUV radiation beam B' onto an exposure region (or illumination region) in an image plane of projection system PS. The exposure region and the radiation beam B' in this image plane (which generally coincides with a surface of the substrate W) are generally the same shape and size.

In use, a plurality of distinct target regions (which may correspond to one or more dies) of a substrate W may be sequentially exposed by moving the substrate table WT relative to the projection system PS between exposures (so as to change which of the target regions is disposed in the exposure region of the image plane). In addition, each such exposure may be a scanning exposure during which the substrate table WT moves in a scanning direction relative to the projection system PS such that the target region being exposed moves, or scans, through the exposure region in the scanning direction. To achieve this functionality, the lithographic apparatus LA is provided with actuators for moving the substrate table WT relative to the projection system PS. These actuators may be considered to form a scanning mechanism configured to control relative positions of the substrate table WT and the projection system PS. For such embodiments, the lithographic apparatus LA may be referred to as a lithographic scanner. The scanning mechanism may be configured to position the substrate table such that a substrate supported by the substrate table lies generally in the image plane. The scanning mechanism may be further configured to move the substrate table so as to scan a target region of the substrate through the exposure region.

In a lithographic scanner, the exposure region in the image plane of projection system PS is elongate and, in this image plane (which generally coincides with a surface of the substrate W), the radiation beam B' is a generally elongate band (either straight or curved) of radiation. The opening in the body of the projection system PS (through which the patterned EUV radiation beam B' is projected onto the substrate W) may be have a generally similar shape and may be slightly larger than the exposure region and the band of radiation. The elongate exposure region in the image plane of projection system PS or the elongate band of radiation may be referred to as a slit or an exposure slit.

In general, in a scanning lithographic apparatus LA, the exposure region is elongate having a longer dimension and a shorter dimension. The shorter dimension may coincide with a scanning direction of the support structure MT and the longer dimension may coincide with a non-scanning direction of the support structure MT. The exposure region may be curved or straight. In the following, and the accompanying Figures, the non-scanning direction of the lithographic apparatus LA is referred to, or labelled as, the x-direction and the scanning direction of the lithographic apparatus LA is referred to, or labelled as, the y-direction. A direction perpendicular to the exposure region is referred to, or labelled as, the z-direction. The longer dimension (the x-direction) of the exposure region is perpendicular to the plane of Figure 1 and the shorter dimension (in the y-direction) of the exposure region lies in the plane of Figure 1.

Each point in the exposure region of the image plane will, in general, receive a cone of radiation (i.e. will receive radiation beams with a range of angles of incidence). Therefore, proximate the opening, the interior of the body of the projection system PS may taper inwards towards the opening (in both directions perpendicular to an optical axis of the patterned EUV radiation beam B'). This tapered portion of the housing proximate the opening may be described as generally funnel shaped and may be referred to as a funnel portion.

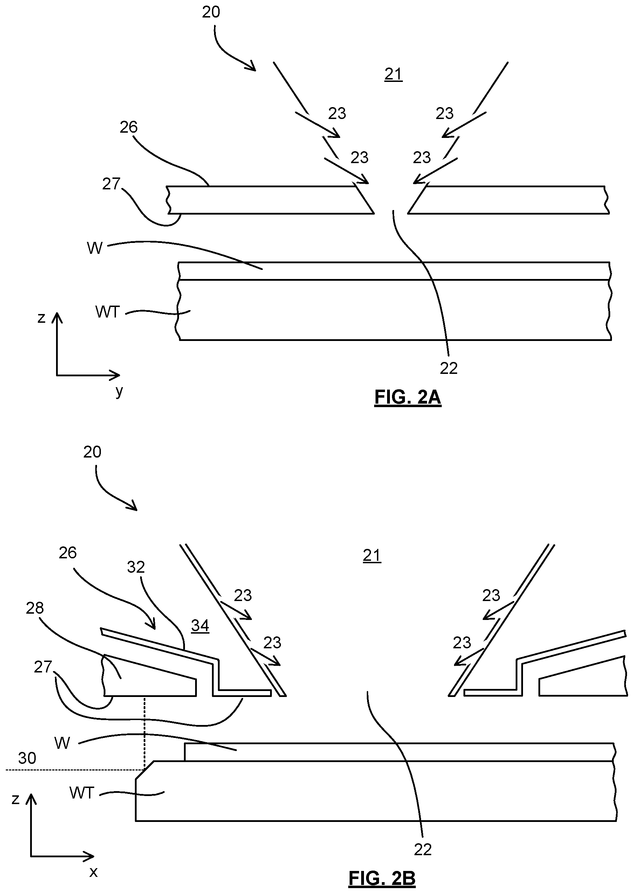

A portion of the lithographic apparatus LA shown in Figure 1 in the vicinity of the substrate table WT (and the substrate W) is now described with reference to schematic Figures 2A and 2B.

Figures 2A and 2B show a system 20 comprising a substrate table WT for supporting a substrate W and a part of the projection system PS. Figure 2A shows the system 20 in cross section in a plane containing the scanning direction (the y-direction). Figure 2B shows the system 20 in cross section in a plane containing the non-scanning direction (the x-direction).

The system 20 forms part of the lithographic apparatus LA shown schematically in Figure 1. Figures 2A and 2B shows a portion of a body or housing of the projection system, which defines an interior 21 and an opening 22 (only a tapered portion of the interior 21 proximate the opening 22 is shown). Note that an extent of the opening 22 is greater in the non-scanning direction (see Figure 2B) than in the scanning direction (see Figure 2A).

The system 20 further comprises a gas lock arranged to provide a gas flow through the opening away from the interior of the projection system PS. This gas flow is indicated schematically by arrows 23, indicating that the gas is directed through apertures in an interior wall of the body or housing of the projection system and into interior 21. The gas flow 23 may comprise any suitable gas such as, for example, hydrogen or nitrogen. The apertures are arranged to direct the gas flow 23 generally towards opening 22. By doing so, the gas lock protects the interior of the projection system PS from the ingress of contaminants. For example, it can prevent such contaminants impinging on the mirrors 13, 14 which, in turn, improves the optical performance of the projection system PS.

The system 20 further comprises a barrier 26 that defines a surface 27 that is generally parallel to the substrate table WT (and any substrate W supported thereby). The barrier 26 surrounds and extends away from a portion of the projection system proximate the opening 22. The barrier 26 may be considered to form part of, or be an extension of, the body or housing of the projection system PS.

It will be appreciated that the barrier 26 may be formed from a plurality of different components.

For example, the barrier 26 may comprise a substrate table heat shield (for example in the cross section shown in Figure 2A), which may be arranged to at least partially thermally isolate the substrate table WT (and any substrate W supported thereby), which it may be desired to maintain at a particular temperature, from other parts of the apparatus (for example other parts of lithographic apparatus LA). Such a substrate table heat shield may comprise a water-cooled plate.

Additionally or alternatively, the barrier 26 may comprise or incorporate one or more mirrors 28 (see Figure 2B) that may be used as part of a measurement system that is arranged to measure the position of the substrate table WT relative to the barrier 26 and/or the projection system PS (or, equivalently, relative to the isolated frame to which the barrier 26 and projection system PS are attached). In use, one or more interferometer beams 30 may be emitted towards the substrate table, for example from an isolated frame to which the barrier 26 and projection system PS. The interferometric beam 30 is reflected from the substrate table WT towards the mirror 28. The interferometric beam 30 is reflected from the mirror 28 and propagates back to an interferometric device that is operable to determine a position of the substrate table WT relative to the barrier 26 and/or the projection system PS (or, equivalently, relative to the isolated frame to which the barrier 26 and projection system PS are attached) in a direction generally perpendicular to a plane of the substrate table WT (which may be referred to as a z-direction). Such interferometric devices may be referred to as position sensors.

The barrier 26 may comprise additional components such as, for example, an access hatch or door, which can be moved, or removed, to provide access to the interior 21 of the projection system PS.

Within an EUV lithographic apparatus, some parts of the apparatus may be subject to contamination, for example, in the presence of EUV radiation from the radiation beam B'. Parts of the apparatus at substrate level may be particularly susceptible to such contamination. When the EUV radiation illuminates the substrate W contaminants may be released from the substrate W. These contaminants may be transported by the gas flow 23 to other parts of the system 20. It is desirable to avoid contamination of the mirrors 28, which may cause a reduction in the accuracy with which the z position of the substrate table WT (relative to the barrier 26) can be determined and/or may necessitate cleaning and/or replacement of the mirrors 28.

As shown schematically in Figure 2B, the system 20 further comprises a spoiler 32 which forms part of the barrier and which is disposed between the opening 22 and the mirrors 28. The spoiler 32 is configured to direct a part of the gas flow 23 away from the mirrors 28, for example into a region 34 that bypasses the mirror 28. Advantageously, this can reduce a concentration of contaminants deposited on the mirror 28.

Some embodiments of the present disclosure further comprise at least one deformable partition either: (a) extending partially from the substrate table WT towards the surface 27 facing the substrate table WT in use (for example while the projection system PS is projecting the patterned radiation beam B' onto a substrate W supported by the substrate table WT); or (b) extending partially from the surface 27 facing the substrate table WT in use (for example while the projection system PS is projecting the patterned radiation beam B' onto a substrate W supported by the substrate table WT) towards the substrate table WT.

In use, while the projection system PS is projecting the patterned radiation beam B' onto a substrate W supported by the substrate table WT, the substrate table WT is positioned such that part of the substrate receives the patterned radiation B' from the projection system PS (through opening 22). The rest of the substrate W faces a generally parallel surface 27, which may, for example, comprise a heat shield.

As discussed further below, it can be beneficial to reduce a gap between some parts of the substrate W and surrounding apparatus (for example, to reduce the amount of particles and/or radiation passing to or from certain parts of the substrate W). To this end, it may be beneficial to reduce the distance between the substrate table WT (or substrate W) and the facing surface 27. However, there is a limit to the minimum distance that can be achieved as it is undesirable for the substrate W or substrate table WT to contact the facing surface 27. Furthermore, some tolerance may be allowed to prevent such contact in the event of an earthquake or the like to prevent damage to the substrate W, substrate table WT or the facing surface 27.

Advantageously, the at least one deformable partition of the lithographic apparatus according to the present disclosure further reduces a gap between some parts of the substrate W and surrounding apparatus. The at least one deformable partition extends from a first member (at its proximal end) partially towards a second member (at its distal end). The first and second members are: (a) the substrate table WT; or (b) a surface 27 facing the substrate table WT during use. If the first and second members move towards each other (for example in the event of an earthquake) the second member may contact the distal end of the deformable partition, causing it to deform. Since the at least one partition is deformable, advantageously, such contact may not result in damage to either the substrate table WT or the surface 27 facing it in use (for example a heat shield). Advantageously, therefore, the lithographic apparatus according to the present disclosure allows a physical gap between the substrate table WT (or substrate W) and an adjacent surface 27 to be reduced whilst limiting the risk of damage.

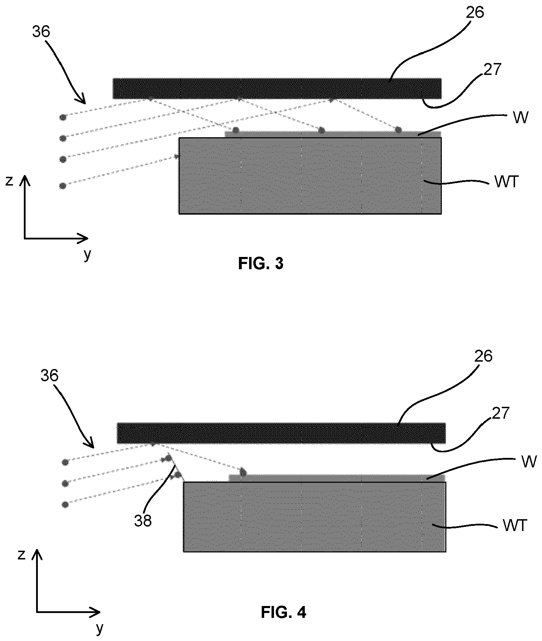

Example embodiments of such deformable partitions are described further below with reference to Figures 3 to 17B.

In some embodiments of the present disclosure, at least one deformable partition extends partially from the substrate table WT towards the surface 27 facing the substrate table WT in use while the projection system PS is projecting the patterned radiation beam B' onto a substrate W supported by the substrate table WT, as now discussed with reference to Figures 3 to 7B.

As explained above the surface 27 facing the substrate table WT may comprise, or may be at least partially formed by, a heat shield.

Figure 3 shows a section of the substrate table WT (supporting a substrate W) and the generally parallel barrier 26 with no deformable partition. Also shown in Figure 3 are potential trajectories 36 of particles released from the surrounding environment. As represented schematically in Figure 3, these trajectories 36 illustrate that such particles from the surrounding environment can rebound from the barrier 26 and be incident on the substrate W. This is undesirable as it may result in printing errors and any resultant integrated circuit may be defective as a result.

Figure 4 shows the same section of the substrate table WT, the substrate W and the barrier 26 as shown in Figure 3. In addition, Figure 4 shows a deformable partition 38 extending partially from the substrate table WT towards the surface 27. Also shown in Figure 4 are potential trajectories 36 of particles released from the surrounding environment. As can be seen from a comparison of Figures 3 and 4, some of the potential trajectories 36 that would reach the substrate W in the absence of the deformable partition 38 (see Figure 3) are now blocked by the deformable partition 38 (see Figure 4).

Advantageously, the deformable partition 38 that extends partially from the substrate table WT to the surface 27 provides a barrier between a portion of the substrate table WT that supports the substrate W and the surrounding portions of the substrate table WT and the surrounding environment. Since the deformable partition 38 extends from the substrate table WT it remains in a fixed position relative to a substrate W supported by the substrate table WT.

It is desirable to reduce the number of particles incident on the substrate W in order to reduce the incidence of wafer defects. The deformable partition 38 acts to further reduce ingress of particles to a region in which the substrate W is disposed from surrounding environments.

It will be appreciated that the at least one deformable partition 38 that extends partially from the substrate table WT to the surface 27 facing the substrate table WT during use has at least a component of extent in a direction perpendicular to a plane of the substrate W (i.e. the z-direction).

In principle, the at least one deformable partition 38 that extends partially from the substrate table WT towards the surface 27 facing the substrate table may extend substantially entirely around a perimeter (or circumference) of a region for supporting the substrate W. This would maximize the separation between the portion of the substrate table WT that supports the substrate W and the surrounding portions of the substrate table WT and the surrounding environment.

However, in some embodiments the at least one deformable partition 38 that extends partially from the substrate table WT to the surface 27 facing the substrate table WT extends only partially around a perimeter of a region of the substrate table WT that, in use, supports the substrate W.

For example, in some embodiments the at least one deformable partition 38 that extends partially from the substrate table WT to the surface 27 facing the substrate table WT extends along two opposed surfaces of a generally rectangular region of the substrate table WT for supporting the substrate W.

Advantageously, such an arrangement may allow line of sight for a laser beam 30 to pass from the surrounding environment to a portion of the substrate table WT that is adjacent to a portion of the substrate table WT that supports the substrate W. As discussed above with reference to Figure 2B, such a laser beam 30 may be used, for example, as part of an interferometric measurement system for measuring the position (for example the height or z-position) of the substrate table WT relative to a reference frame.

For example, with the arrangement of system 20 as shown in Figures 2A and 2B above, the system 20 may comprise two deformable partitions 38, each extending generally in the non-scanning direction (x-direction) along one of two opposed surfaces of a generally rectangular region of the substrate table WT for supporting the substrate W.

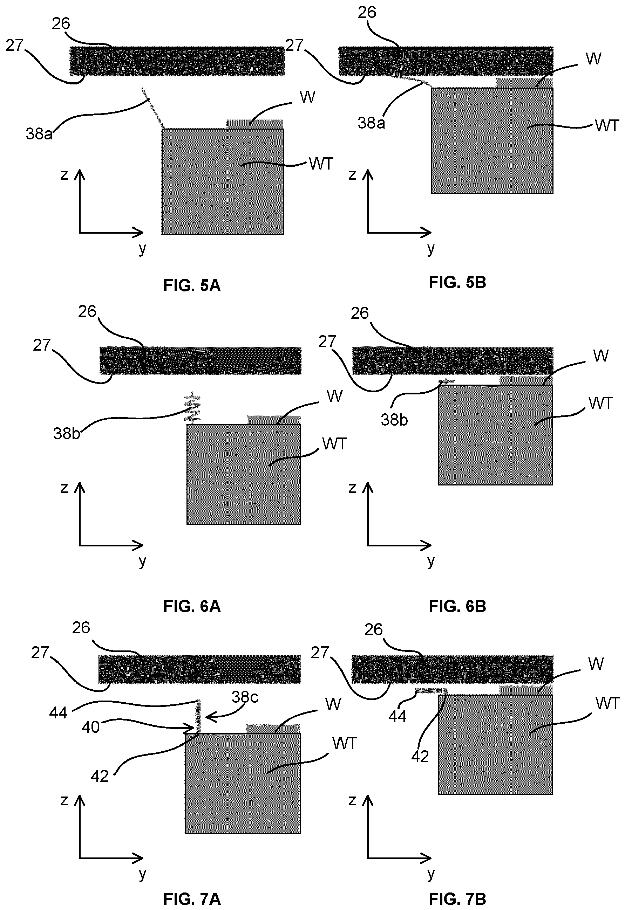

In some embodiments, the at least one deformable partition 38 may be resiliently deformable, as now discussed with reference to Figures 5A to 6B.

In a first example embodiment of a deformable partition 38 that extends partially from the substrate table WT towards the facing surface 27, deformable partition 38 is a resiliently deformable partition 38a having at least a component of extent in a direction parallel to a plane of the substrate W. Such a resiliently deformable partition 38a is shown in Figures 5A and 5B.

Figure 5A shows the same section of the substrate table WT, the substrate W and the barrier 26 as shown in Figure 4 with a resiliently deformable partition 38a disposed in nominal position. Figure 5B shows the arrangement as Figure 5A but wherein the substrate table WT and the barrier 26 have been moved together so that the barrier 26 contacts and exerts a force on the resiliently deformable partition 38a disposed in nominal position.

Rather than extending solely perpendicular to the plane of the substrate W (i.e. in the z-direction alone), the resiliently deformable partition 38a extends at an oblique angle to the plane of the substrate W. As can be seen in Figure 5B, upon exertion of a force from an object (for example the barrier 26) generally perpendicular to the plane of the substrate W (i.e. generally in the z-direction) such a resiliently deformable partition 38a can bend to the side without damaging itself or the barrier 26.

In a second example embodiment of a deformable partition 38 that extends partially from the substrate table WT towards the facing surface 27, deformable partition 38 is a resiliently deformable partition 38b that is resiliently deformable in a direction generally perpendicular to the plane of the substrate W (i.e. in the z-direction). Such a resiliently deformable partition 38b is shown in Figures 6A and 6B.

Figure 6A shows the same section of the substrate table WT, the substrate W and the barrier 26 as shown in Figure 4 with a resiliently deformable partition 38b disposed in nominal position. Figure 6B shows the arrangement as Figure 6A but wherein the substrate table WT and the barrier 26 have been moved together so that the barrier 26 contacts and exerts a force on the resiliently deformable partition 38b disposed in nominal position.

In a direction perpendicular to the plane of the substrate W, the resiliently deformable partition 38b of this embodiment is generally of the form of a spring. Upon exertion of a force from an object (for example the barrier 26) generally perpendicular to the plane of the substrate W (i.e. generally in the z-direction) such a resiliently deformable partition 38b may compress in said direction.

Advantageously, such a resiliently deformable partition 38a, 38b can deform from a nominal position if its distal end contacts another object 26 (for example during an earthquake) and can move back to the nominal position when the object causing the deformation is removed.

In some embodiments, the at least one deformable partition 38 may comprise a frangible portion between its proximate and distal ends, as now discussed with reference to Figures 7A to 7B.

In a third example embodiment of a deformable partition 38c that extends partially from the substrate table WT towards the facing surface 27, the deformable partition 38c comprises a frangible portion between its proximate and distal ends. Such a deformable partition 38c is shown in Figures 7A and 7B.

Figure 7A shows the same section of the substrate table WT, the substrate W and the barrier 26 as shown in Figure 4 with a deformable partition 38c disposed in nominal position. A frangible portion 40 is provided between a proximate end 42 of the deformable partition 38c and a distal end 44 of the deformable partition 38c.

Figure 7B shows the arrangement as Figure 7A but wherein the substrate table WT and the barrier 26 have been moved together so that the barrier 26 has contacted and exerted a force on the deformable partition 38c disposed in nominal position.

Advantageously, such a frangible portion 40 allows the deformable partition 38c to break if its distal end 44 contacts another object (for example during an earthquake). Such a deformable partition 38c may be described as permanently deformable.

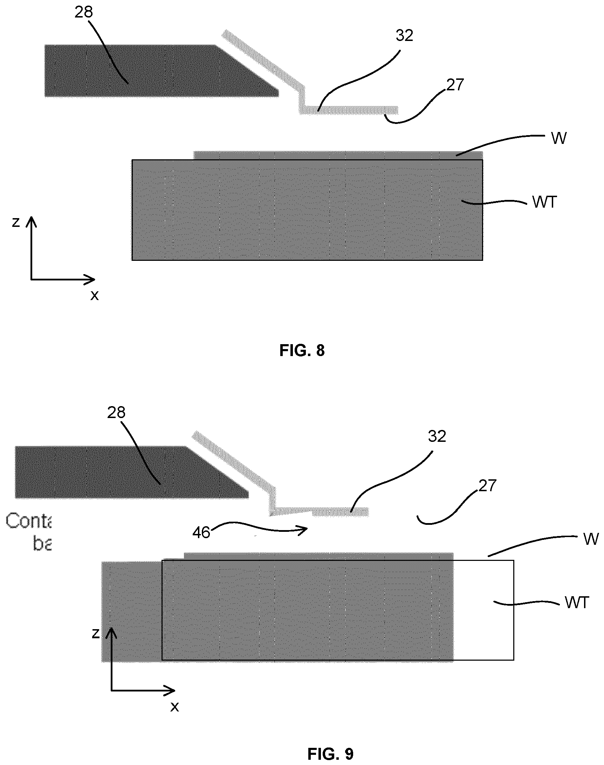

In some embodiments of the present disclosure, at least one deformable partition extends partially towards the substrate table WT from the surface 27 facing the substrate table WT in use while the projection system PS is projecting the patterned radiation beam B' onto a substrate W supported by the substrate table WT, as now discussed with reference to Figures 8 to 17B.

The deformable partition that extends partially towards the substrate table WT from the surface 27 facing the substrate table WT may extend substantially entirely around a perimeter the exposure region. Alternatively, the at least one deformable partition that extends partially towards the substrate table WT from the surface 27 facing the substrate table WT may extend only partially around a perimeter the exposure region.

Figure 8 shows a section of the substrate table WT (supporting a substrate W) and part of the generally parallel barrier with no deformable partition. In particular, the barrier comprises a mirror 28 (see Figure 2B) that may be used as part of a measurement system that is arranged to measure the z-position of the substrate table WT relative to the barrier 26 and/or the projection system PS (or, equivalently, relative to the isolated frame to which the barrier 26 and projection system PS are attached). The barrier further comprises a spoiler 32 which forms part of the barrier and which is disposed between the opening 22 and the mirrors 28.

Figure 9 shows the same section of the substrate table WT, the substrate W and the barrier 26 as shown in Figure 8. In addition, Figure 9 shows a deformable partition 46 extending partially from the surface 27 towards the substrate table WT.

In particular, the deformable partition 46 extends from a surface 27 on the spoiler 32 that is adjacent to the mirror 28 used as part of an interferometric measuring system. In this embodiment, the deformable partition 46 extends generally along a scanning direction (i.e. the y-direction).

Advantageously, since the deformable partition 46 extends partially towards the substrate table WT from the surface 27 that faces the substrate table WT during an exposure of the substrate W, the deformable partition 46 can provide a barrier between the exposure region (also known as a slit) and surrounding portions of the apparatus. Since the deformable partition 46 that extends from the surface 27 that, in use, faces the substrate table WT it remains in a fixed position relative to the projection system PS and any other apparatus connected thereto.

It can be desirable to reduce the number of particles egressing from a volume adjacent the exposure region to the surrounding environment. For example, when the EUV radiation illuminates the substrate W contaminants may be released from the substrate W. These contaminants may be transported by the gas flow 23 (see Figures 2A and 2B) to other parts of the system 20. It is desirable to avoid contamination of the mirrors 28, which may cause a reduction in the accuracy with which the z position of the substrate table WT (relative to the barrier 26) can be determined and/or may necessitate cleaning and/or replacement of the mirrors 28. The deformable partition 46 that extends partially to the substrate table WT from the surface 27 that faces the substrate table WT during an exposure of the substrate can achieve this.

It will be appreciated that the deformable partition 46 that extends partially towards the substrate table WT from the surface 27 facing the substrate table WT while the projection system PS is projecting the patterned radiation beam onto a substrate W supported by the substrate table WT has at least a component of extent in a direction perpendicular to a plane of the substrate W (i.e. the z-direction).

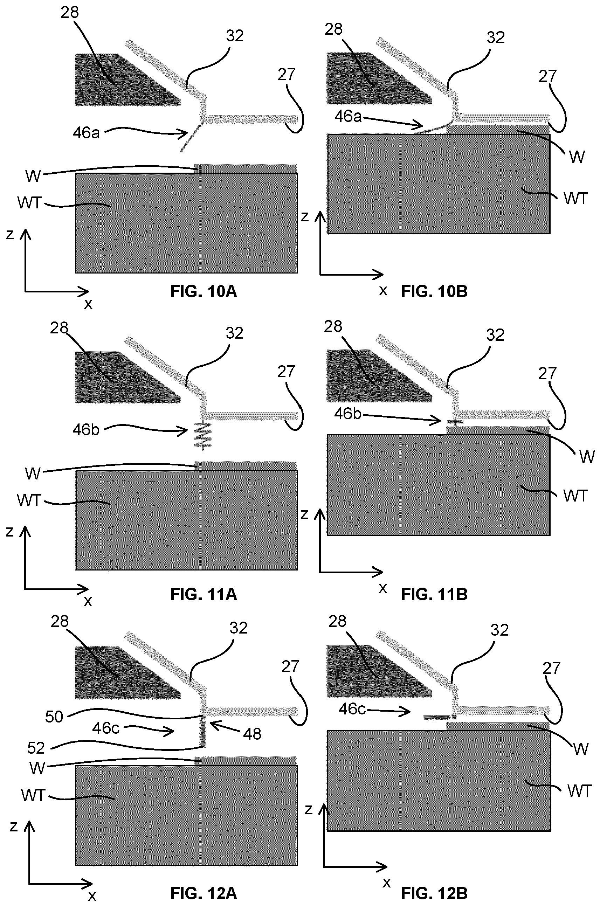

In some embodiments, the at least one deformable partition 46 may be resiliently deformable, as now discussed with reference to Figures 10A to 11B.

In a first example embodiment of a deformable partition 46 that extends partially towards the substrate table WT from the surface 27 adjacent to a mirror 28 used as part of an interferometric measuring system, the deformable partition 46 is a resiliently deformable partition 46a having at least a component of extent in a direction parallel to a plane of the substrate W. Such a resiliently deformable partition 46a is shown in Figures 10A and 10B.

Figure 10A shows the same section of the substrate table WT, the substrate W and the barrier 26 as shown in Figure 9 with a resiliently deformable partition 46a disposed in nominal position. Figure 10B shows the arrangement as Figure 10A but wherein the substrate table WT and the barrier 26 have been moved together so that the substrate W and/or the substrate table WT contacts and exerts a force on the resiliently deformable partition 46a.

Rather than extending solely perpendicular to the plane of the substrate W (i.e. in the z-direction alone), the resiliently deformable partition 46a extends at an oblique angle to the plane of the substrate W. As can be seen in Figure 10B, upon exertion of a force from an object (for example the substrate W and/or the substrate table WT) generally perpendicular to the plane of the substrate W (i.e. generally in the z-direction) such a resiliently deformable partition 46a can bend to the side without damaging itself or the barrier 26 or the substrate table WT.

In a second example embodiment of a deformable partition 46 that extends partially towards the substrate table WT from the surface 27 adjacent to a mirror 28 used as part of an interferometric measuring system, the deformable partition 46 is a resiliently deformable partition 46b that is resiliently deformable in a direction generally perpendicular to the plane of the substrate W (i.e. in the z-direction). Such a resiliently deformable partition 46b is shown in Figures 11A and 11B.

Figure 11A shows the same section of the substrate table WT, the substrate W and the barrier 26 as shown in Figure 4 with a resiliently deformable partition 46b disposed in nominal position. Figure 11B shows the arrangement as Figure 11A but wherein the substrate table WT and the barrier 26 have been moved together so that the substrate W and/or the substrate table WT contacts and exerts a force on the resiliently deformable partition 46b.

In a direction perpendicular to the plane of the substrate W, the resiliently deformable partition 46b of this embodiment is generally of the form of a spring. Upon exertion of a force from an object (for example the substrate W and/or the substrate table WT) generally perpendicular to the plane of the substrate W (i.e. generally in the z-direction) such a resiliently deformable partition 46b may compress in said direction.

Advantageously, such a resiliently deformable partition 46a, 46b can deform from a nominal position if its distal end contacts another object 26 (for example during an earthquake) and can move back to the nominal position when the object causing the deformation is removed.

In some embodiments, the at least one deformable partition 46 may comprise a frangible portion between its proximate and distal ends, as now discussed with reference to Figures 12A to 12B.

In a third example embodiment of a deformable partition 46 that extends partially towards the substrate table WT from the surface 27 adjacent to a mirror 28 used as part of an interferometric measuring system, the deformable partition 46c comprises a frangible portion between its proximate and distal ends. Such a deformable partition 46c is shown in Figures 12A and 12B.

Figure 12A shows the same section of the substrate table WT, the substrate W and the barrier 26 as shown in Figure 9 with a deformable partition 46c disposed in nominal position. A frangible portion 48 is provided between a proximate end 50 of the deformable partition 46c and a distal end 52 of the deformable partition 46c.

Figure 12B shows the arrangement as Figure 12A but wherein the substrate table WT and the barrier 26 have been moved together so that the substrate W and/or the substrate table WT has contacted and exerted a force on the deformable partition 46c.

Advantageously, such a frangible portion 40 allows the deformable partition 46c to break if its distal end 44 contacts another object (for example during an earthquake). Such a deformable partition 46c may be described as permanently deformable.

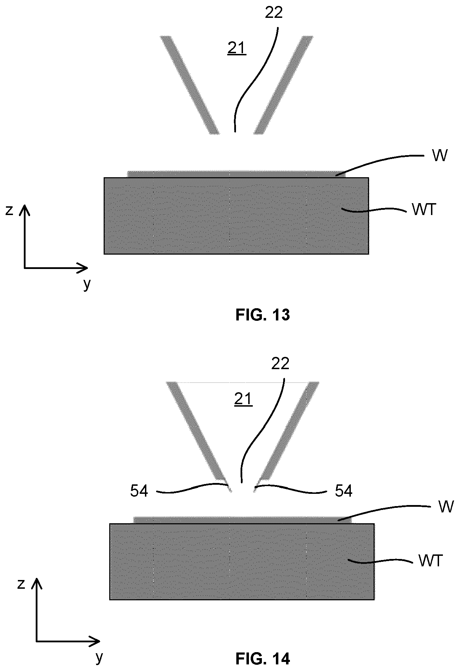

Figure 13 shows a section of the substrate table WT (supporting a substrate W) and part of projection system housing proximate to the opening 22 but with no deformable partition.

Figure 14 shows the same section of the substrate table WT, the substrate W and lower part of projection system housing proximate to the opening 22 as shown in Figure 13. In addition, Figure 14 shows two deformable partitions 54, each extending partially from the housing or the projection system towards the substrate table WT.

In particular, the deformable partitions 54 extend from, and form an extension of, the lower part of projection system housing proximate to the opening 22. The deformable partitions 54 extend from the projection system in the vicinity of the exposure region. In this embodiment, the deformable partitions 54 each extends generally along a non-scanning direction (i.e. the x-direction).

Advantageously, since the deformable partition 54 extends partially towards the substrate table WT from a surface that faces the substrate table WT during an exposure of the substrate W, the deformable partition 54 can provide a barrier between the exposure region (also known as a slit) and surrounding portions of the apparatus. Since the deformable partition 54 that extends from a surface that, in use, faces the substrate table WT it remains in a fixed position relative to the projection system PS and any other apparatus connected thereto.

It can be desirable to reduce the number of particles egressing from a volume adjacent the exposure region to the surrounding environment. For example, when the EUV radiation illuminates the substrate W contaminants may be released from the substrate W. These contaminants may be transported by the gas flow 23 (see Figures 2A and 2B) to other parts of the system 20. It is desirable to avoid contamination of other parts of the substrate W, which may cause wafer defects. Additionally or alternatively, it can be desirable to reduce the amount of radiation from the projection system PS that is incident on the substrate W outside of the exposure region. The deformable partition 54 that extends partially to the substrate table WT from the surface 27 that faces the substrate table WT during an exposure of the substrate can achieve this.

It will be appreciated that the deformable partition 54 that extends partially towards the substrate table WT from the surface facing the substrate table WT while the projection system PS is projecting the patterned radiation beam onto a substrate W supported by the substrate table WT has at least a component of extent in a direction perpendicular to a plane of the substrate W (i.e. the z-direction).

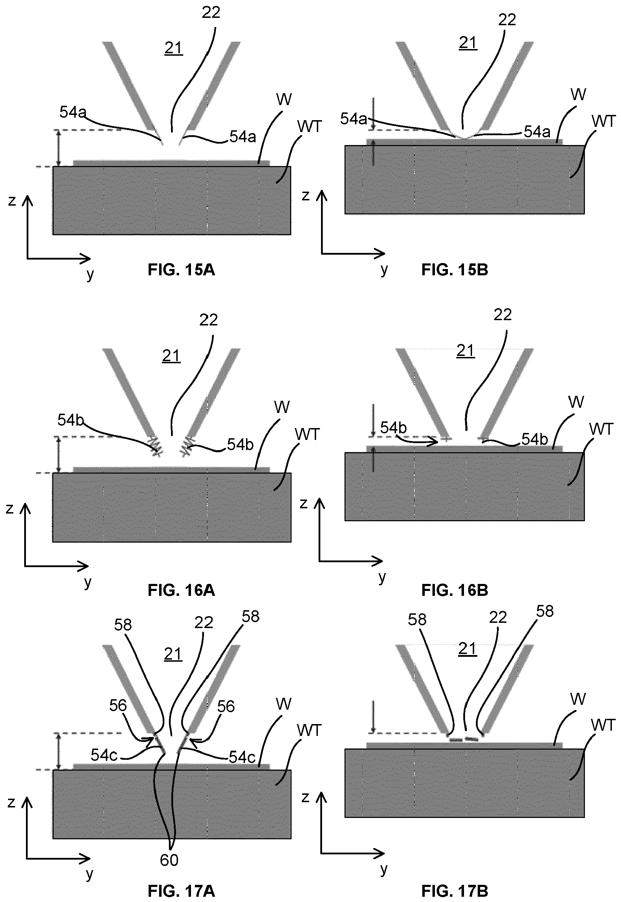

In some embodiments, the at least one deformable partition 54 may be resiliently deformable, as now discussed with reference to Figures 15A to 16B.

In a first example embodiment of a deformable partition 54 that extends from the projection system in the vicinity of an exposure region, the deformable partition 54 is a resiliently deformable partition 54a having at least a component of extent in a direction parallel to a plane of the substrate W. Such a resiliently deformable partition 54a is shown in Figures 15A and 15B.

Figure 15A shows the same section of the substrate table WT, the substrate W and the lower portion of the projection system PS as shown in Figure 14 with a resiliently deformable partition 54a disposed in nominal position. Figure 15B shows the arrangement as Figure 15A but wherein the substrate table WT and the barrier 26 have been moved together so that the substrate W and/or the substrate table WT contacts and exerts a force on the resiliently deformable partition 54a.

Rather than extending solely perpendicular to the plane of the substrate W (i.e. in the z-direction alone), the resiliently deformable partition 54a extends at an oblique angle to the plane of the substrate W. As can be seen in Figure 15B, upon exertion of a force from an object (for example the substrate W and/or the substrate table WT) generally perpendicular to the plane of the substrate W (i.e. generally in the z-direction) such a resiliently deformable partition 54a can bend to the side without damaging itself or the barrier 26 or the substrate table WT.

In a second example embodiment of a deformable partition 54 that extends from the projection system in the vicinity of an exposure region, the deformable partition 54 is a resiliently deformable partition 54b that is resiliently deformable in a direction generally perpendicular to the plane of the substrate W (i.e. in the z-direction). Such a resiliently deformable partition 54b is shown in Figures 16A and 16B.

Figure 16A shows the same section of the substrate table WT, the substrate W and the lower portion of the projection system PS as shown in Figure 14 with a resiliently deformable partition 54b disposed in nominal position. Figure 16B shows the arrangement as Figure 16A but wherein the substrate table WT and the barrier 26 have been moved together so that the substrate W and/or the substrate table WT contacts and exerts a force on the resiliently deformable partition 54b.

In a direction perpendicular to the plane of the substrate W, the resiliently deformable partition 54b of this embodiment is generally of the form of a spring. Upon exertion of a force from an object (for example the substrate W and/or the substrate table WT) generally perpendicular to the plane of the substrate W (i.e. generally in the z-direction) such a resiliently deformable partition 54b may compress in said direction.

Advantageously, such a resiliently deformable partition 54a, 54b can deform from a nominal position if its distal end contacts another object 26 (for example during an earthquake) and can move back to the nominal position when the object causing the deformation is removed.

In some embodiments, the at least one deformable partition 54 may comprise a frangible portion between its proximate and distal ends, as now discussed with reference to Figures 17A to 17B.

In a third example embodiment of a deformable partition 54 that extends from the projection system in the vicinity of an exposure region, the deformable partition 54c comprises a frangible portion between its proximate and distal ends. Such a deformable partition 54c is shown in Figures 17A and 17B.

Figure 17A shows the same section of the substrate table WT, the substrate W and the barrier 26 (lower portion of the projection system) as shown in Figure 14 with a deformable partition 54c disposed in nominal position. A frangible portion 56 is provided between a proximate end 58 of the deformable partition 54c and a distal end 60 of the deformable partition 54c.

Figure 17B shows the arrangement as Figure 17A but wherein the substrate table WT and the barrier 26 have been moved together so that the substrate W and/or the substrate table WT has contacted and exerted a force on the deformable partition 54c.

Advantageously, such a frangible portion 56 allows the deformable partition 54c to break if its distal end 60 contacts another object (for example during an earthquake). Such a deformable partition 54c may be described as permanently deformable.

Although various embodiments of deformable partitions 38, 46, 54 have been described separately above, it will be appreciated that other embodiments comprise any combination of these deformable partitions 38, 46, 54.

The substrate table WT shown in Figures 4 to 7B and described above is shown and described with reference also to a barrier 26 having a surface 27 that, in use, faces and is adjacent to the substrate table WT and substrate W. Some embodiments of the present disclosure relate to a substrate table WT alone having a deformable partition 38 extending from the substrate table WT generally of the form of the substrate table WT shown in Figures 4 to 7B and described above.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

### Clauses

1. A system comprising:
   a substrate table arranged to support a substrate;
   a device, wherein the system is configurable in a first configuration such that a surface of the device faces and is adjacent to the substrate and the substrate table; and
   at least one deformable partition either: (a) extending partially from the substrate table towards the surface of the device when the system is in the first configuration; or (b) extending partially from the surface of the device that faces and is adjacent to the substrate and the substrate table when the system is in the first configuration towards the substrate table.
2. The system of clause 1 wherein the device comprises a projection system configured to project a patterned radiation beam through an opening and onto a substrate supported by the substrate table.
3. The system of clause 2 wherein the device further comprises one or more components extending from the opening and at least partially defining the surface of the device that faces and is adjacent to the substrate and the substrate table when the system is in the first configuration.
4. The system of any preceding clause wherein at least one deformable partition extends partially from the substrate table towards the surface of the device that faces and is adjacent to the substrate and the substrate table when the system is in the first configuration.
5. The system of clause 4 wherein the at least one deformable partition that extends partially from the substrate table towards the surface of the device that faces and is adjacent to the substrate and the substrate table when the system is in the first configuration extends only partially around a perimeter of a region of the substrate table for supporting the substrate.
6. The system of any preceding clause further comprising a scanning mechanism configured to control relative positions of the substrate table and the device.
7. The system of any preceding clause wherein at least one deformable partition extends partially towards the substrate table from a surface of the device that faces and is adjacent to the substrate and the substrate table when the system is in the first configuration.
8. The system of clause 7 wherein the at least one deformable partition that extends partially towards the substrate table from the surface of the device that faces and is adjacent to the substrate and the substrate table when the system is in the first configuration comprises at least one deformable partition extending from a projection system in the vicinity of an exposure region.
9. The system of clause 8 when dependent either directly or non-directly on clause 6 wherein the at least one deformable partition extending from the projection system in the vicinity of an exposure region extends generally along a non-scanning direction.
10. The system of any one of clauses 7 to 9 wherein the at least one deformable partition that extends partially towards the substrate table from the surface of the device that faces and is adjacent to the substrate and the substrate table when the system is in the first configuration comprises at least one deformable partition extending from a surface adjacent to a mirror used as part of an interferometric measuring system.
11. The system of clause 10 when dependent either directly or non-directly on clause 6 wherein the at least one deformable partition extending from a surface adjacent to a mirror used as part of an interferometric measuring system extends generally along a scanning direction.
12. The system of any preceding clause wherein at least one of the at least one deformable partition is resiliently deformable.
13. The system of clause 12 wherein said resiliently deformable partition has at least a component of extent in a direction parallel to a plane of the substrate.
14. The system of clause 12 wherein said resiliently deformable partition is resiliently deformable in a direction generally perpendicular to the plane of the substrate.
15. The system of any preceding clause wherein at least one of the at least one deformable partition comprises a frangible portion between its proximate and distal ends.
16. A substrate table for use in the system of any preceding clause.
17. A device for use in the system of any one of clauses 1 to 15.
18. A substrate table arranged to support a substrate, the substrate table comprising at least one deformable partition extending from the substrate table and having at least a component of extent in a direction perpendicular to a plane of a substrate when supported by the substrate table.
19. The substrate table of clause 18 wherein the at least one deformable partition that extends from the substrate table extends only partially around a perimeter of a region of the substrate table for supporting the substrate.
20. The substrate table of clause 18 or clause 19 wherein at least one of the at least one deformable partition is resiliently deformable.
21. The substrate table of clause 20 wherein said resiliently deformable partition has at least a component of extent in a direction parallel to a plane of the substrate when supported by the substrate table.
22. The substrate table of clause 20 wherein said resiliently deformable partition is resiliently deformable in a direction generally perpendicular to the plane of the substrate when supported by the substrate table.
23. The substrate table of any one of clauses 18 to 22 wherein at least one of the at least one deformable partition comprises a frangible portion between its proximate and distal ends.
24. A lithographic apparatus comprising the system according to one of clauses 1-15 or the substrate table according to one of clauses 18-23.

## Claims

1. A system comprising:
a substrate table arranged to support a substrate;
a device, wherein the system is configurable in a first configuration such that a surface of the device faces and is adjacent to the substrate and the substrate table; and
at least one deformable partition either: (a) extending partially from the substrate table towards the surface of the device when the system is in the first configuration; or (b) extending partially from the surface of the device that faces and is adjacent to the substrate and the substrate table when the system is in the first configuration towards the substrate table.

2. The system of claim 1 wherein the device comprises a projection system configured to project a patterned radiation beam through an opening and onto a substrate supported by the substrate table.

3. The system of claim 2 wherein the device further comprises one or more components extending from the opening and at least partially defining the surface of the device that faces and is adjacent to the substrate and the substrate table when the system is in the first configuration.

4. The system of any preceding claim wherein at least one deformable partition extends partially from the substrate table towards the surface of the device that faces and is adjacent to the substrate and the substrate table when the system is in the first configuration.

5. The system of claim 4 wherein the at least one deformable partition that extends partially from the substrate table towards the surface of the device that faces and is adjacent to the substrate and the substrate table when the system is in the first configuration extends only partially around a perimeter of a region of the substrate table for supporting the substrate.

6. The system of any preceding claim further comprising a scanning mechanism configured to control relative positions of the substrate table and the device.

7. The system of any preceding claim wherein at least one deformable partition extends partially towards the substrate table from a surface of the device that faces and is adjacent to the substrate and the substrate table when the system is in the first configuration.

8. The system of claim 7 wherein the at least one deformable partition that extends partially towards the substrate table from the surface of the device that faces and is adjacent to the substrate and the substrate table when the system is in the first configuration comprises at least one deformable partition extending from a projection system in the vicinity of an exposure region.

9. The system of claim 8 when dependent either directly or non-directly on claim 6 wherein the at least one deformable partition extending from the projection system in the vicinity of an exposure region extends generally along a non-scanning direction.

10. The system of any one of claims 7 to 9 wherein the at least one deformable partition that extends partially towards the substrate table from the surface of the device that faces and is adjacent to the substrate and the substrate table when the system is in the first configuration comprises at least one deformable partition extending from a surface adjacent to a mirror used as part of an interferometric measuring system.

11. The system of claim 10 when dependent either directly or non-directly on claim 6 wherein the at least one deformable partition extending from a surface adjacent to a mirror used as part of an interferometric measuring system extends generally along a scanning direction.

12. The system of any preceding claim wherein at least one of the at least one deformable partition is resiliently deformable.

13. The system of claim 12 wherein said resiliently deformable partition has at least a component of extent in a direction parallel to a plane of the substrate, or
wherein said resiliently deformable partition is resiliently deformable in a direction generally perpendicular to the plane of the substrate, or
wherein at least one of the at least one deformable partition comprises a frangible portion between its proximate and distal ends.

14. A substrate table arranged to support a substrate, the substrate table comprising at least one deformable partition extending from the substrate table and having at least a component of extent in a direction perpendicular to a plane of a substrate when supported by the substrate table.

15. A lithographic apparatus comprising the system according to one of claims 1-13 or the substrate table according to claim 14.
